# EUROPEAN PATENT SPECIFICATION

(11) **EP 1 424 735 B1**
(45) Date of publication and mention of the grant of the patent: **28.07.2010**
(21) Application number: 02733434.1
(22) Date of filing: 10.06.2002
(51) Int. Cl.: H01L 31/032, C23C 14/06, C23C 14/34

(54) **METHOD FOR FORMING LIGHT-ABSORBING LAYER**
VERFAHREN ZUR AUSBILDUNG EINER LICHTABSORBIERENDEN SCHICHT
PROCEDE DE FORMATION D'UNE COUCHE ABSORBANT LA LUMIERE

(30) Priority: 06.07.2001 JP 2001244973; 10.10.2001 JP 2001348084
(43) Date of publication of application: 02.06.2004
(73) Proprietor: HONDA GIKEN KOGYO KABUSHIKI KAISHA, Minato-ku, Tokyo 107-8556 (JP)
(72) Inventor: TAKEUCHI, Nobuyoshi, Sayama-shi, Saitama (JP); KUME, Tomoyuki,, Sayama-shi, Saitama, (JP); KOMARU, Takashi,, Sayama-shi, Saitama, (JP)
(74) Representative: Böhm, Brigitte
(86) International application number: PCT/JP2002/005730
(87) International publication number: WO 2003/005456

(56) References cited:
- EP-A2- 0 838 864
- JP-A- 3 268 335
- JP-A- 5 039 562
- JP-A- 5 166 726
- JP-A- 5 182 911
- JP-A- 2000 303 164
- JP-A- 2001 035 861
- JP-A- 2002 083 824
- US-A- 5 000 834
- US-A- 5 439 575

## Description

The present invention relates to a light absorbing layer forming method.

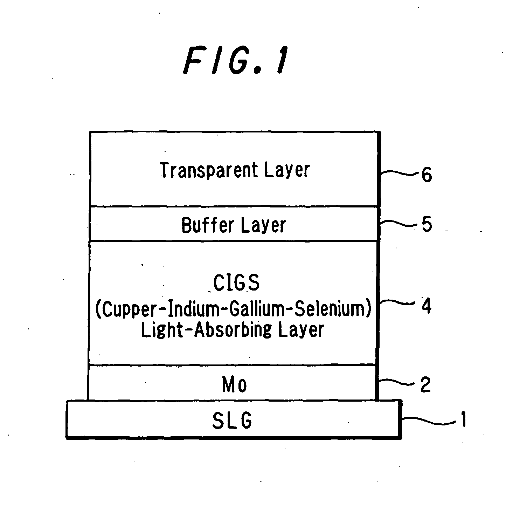

Fig. 1 shows a basic structure of a thin-film solar cell fabricated from a general compound semiconductor, which comprises a SLG (soda lime glass) substrate 1 on which a positive electrode layer (Mo) 2, a light absorbing layer 4, a buffer layer 5 (ZnS, Cds, etc.) and a transparent negative electrode layer (ZnO, Al, etc) are subsequently formed the described order. In the compound semiconductor thin-film solar cell, the light absorbing layer 4 is a CIGS thin film formed of Cu (In+Ga)Se2 of I-III-VI2 group based on Cu, (In, Ga), Se2, which possesses high power conversion efficiency exceeding 20%. The high quality CIGS thin layer having high power conversion efficiency can be formed by a vacuum evaporation method which, however, requires a much time to form layers and, therefore, decreases throughput of the products. A sputtering method may achieve high speed forming of a thin layer of CIGS with reduced times of supplying raw materials owing to long life of each material target and with high reproducibility of quality of formed layers owing to high stability of targets itself. This method, however, cannot obtain the CIGS thin layer having power conversion efficiency comparable with that of the layer formed by a vacuum evaporation method. The reason for the above is explained by that when forming a CIDS thin layer by sputtering at the same time respective single metal targets (e.g., Cu, In and Se), negative ions sputtered mainly from the target Se give damages by shock to the layer being formed, thus causing many defects in the CIDS thin layer formed (T. Nakada et al. "CuInSe2 Films for Solar Cells by Multi-Source Sputtering of Cu, In and Se-Cu Binary Alloy" Proc. 4th Photovoltaic Science and Engineering Conf. 1989, pp.371-375.) Consequently, the power conversion coefficient of a solar cell with a CIGS layer formed by sputtering Se reaches only a range of 6 to 8%.

It has been reported that a CIGS thin layer was formed by depositing Se separately from other components to avoid the damage of the layer by negative ions of Se and a final product has attained the power conversion efficiency exceeding 10% (T. Nakada et al. "Microstructure Characterization for Sputter-Deposited CuInSe2 Films and Photovoltaic Device" Jpn. Appl. Phys. 34, 1995, pp.371-375). However, this method involves such a problem that a Cu target and an In target may be contaminated with vapor of Se and compounds such as CuSe and InSe are produced on their contaminated surfaces, resulting in unstable sputtering.

There is known a conventional method of forming a light absorbing layer of CIGS, which is so called selenization method by which a Se compound is formed by thermo-chemical reaction of a thin-film metal precursor with Se supplied from a source such as H2Se gas.

U.S. Patent No.4798660 discloses a method in which a thin metal film with a metal back-electrode layer, a pure copper (Cu) single layer and a pure indium (In) single layer sequentially deposited thereon by a DC magnetron sputtering method is selenized in an atmosphere of Se (preferably in H2Se gas) to produce a light absorbing layer having a homogeneous composition of CIS (copper indium diselenium).

U.S. Patent No.4915745 discloses a method of forming a CIGS thin film by thermally treating a precursor laminated of a CU-Ga alloy layer and a pure indium layer in the atmosphere of Se. In this instance, Ga contained in the thin film of CIGS segregate to the Mo electrode layer, thereby the adhesion between the light absorbing layer and the Mo electrode layer is improved. This improves the performance of the solar cell using the CIGS layer.

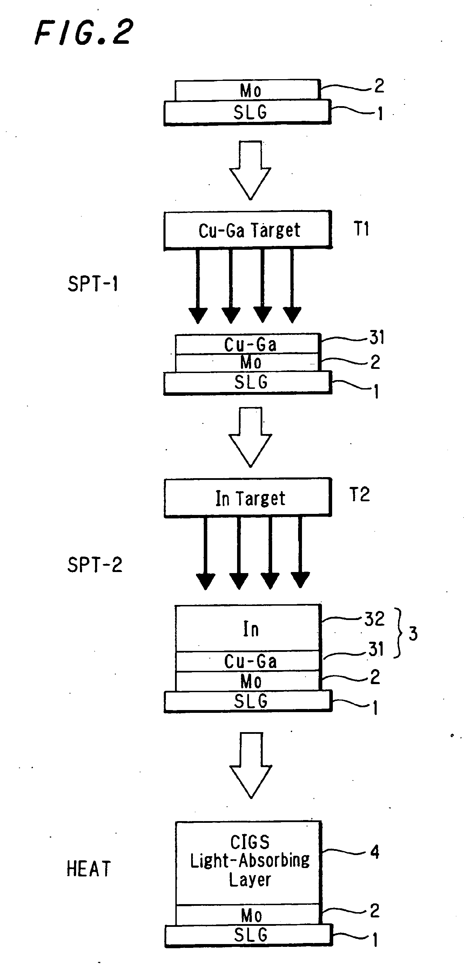

Japanese Laid-Open Patent Publication No. Hei-10-135495 describes a metal precursor which is formed by sputtering first with a target of Cu-Ga alloy and then with a target of pure indium. As shown in Fig. 2, a thin firm of CIG for a light absorbing layer 4 is formed on a Mo electrode layer 2 deposited on a SLG (soda lime glass) substrate 1. Namely, a Cu-Ga metal thin layer 31 is first deposited on the Mo-electrode layer of the substrate by the first sputtering process SPT-1 using the Cu-Ga alloy target and then an In metal thin layer 32 on the Cu-Ga layer 31 by the second sputtering process SPT-2 using the In target to produce a metal-laminated precursor 3' which is then treated by heat in the presence of Selenium (Se) gas to obtain a light absorbing film 4 in the form of a thin CIGS film.

However, this precursor 3' being a laminate of a Cu-Ga alloy layer 31 and a sole In layer 32 may be subjected to solid-state diffusion of elements which react with one another to form an alloy Cu-In-Ga at a boundary between the laminated layers both in process of forming the precursor and in the state of being temporarily stored. This reaction progresses during the selenization of the precursor. As it is difficult to evenly control the alloying reaction process between samples (requiring control of parameters relating to the alloying reaction, for example, temperature, time, etc), the quality of samples of the light absorbing layers 4 may considerably vary. The aggregation of indium is apt to occur, resulting in uneven composition in the layer. In Japanese laid-open Patent publication No. Hei-10--330936, there is disclosed an opposite target type sputtering apparatus for high-speed formation of films on a cooled substrate by using a pair of opposite targets of the same material, in which a space between the paired target is surrounded by a magnetic field to collect sputter plasma therein and deposit a film on the substrate disposed as facing to one of open sides of the space between the targets.

The foregoing methods of manufacturing a light absorbing thin layer of CIGS by heat-treatment in a selenium atmosphere of a laminated precursor film formed in advance by sputtering Ib-IIIb group metals one after another involve a common problem of deterioration in quality of the finished product due to reaction of alloying elements at the boundary between the Cu-Ga layer and the In layer of the precursor, which reaction may progress through the manufacturing processes.

### SUMMARY OF THE INVENTION

Accordingly, an object of the present invention is to provide a method of forming a thin-film light absorbing layer by first forming a precursor film of Ib-IIIb group metals by sputtering and then treating by heat the precursor in an atmosphere of selenium to produce a thin-film of CGIS, wherein the precursor is formed by simultaneously sputtering from a pair of different metal targets disposed opposite to each other to deposit a mixture of sputtered particles on a Mo layer formed on a substrate. This precursor has a well mixed single-layered (not laminated) structure, which is free from alloying reaction of elements at a boundary of layers of a laminated precursor obtained by the conventional method.

Another object of the present invention is to provide a method of forming a light absorbing layer of a solar cell, whereby a thin-film single-layered (i.e., not laminated) precursor is formed by simultaneously supplying Ib group metals and IIIb group metals and then subjected to heat-treatment in an atmosphere of selenium gas. The single-layered precursor can be free from the reaction of alloying elements at a boundary between layers of a laminated precursor obtained by the conventional method.

### BRIEF DESCRIPTION OF THE DRAWINGS

Fig. 1 shows a basic structure of a solar cell of general compound semiconductors in cross section.
Fig. 2 illustrates a conventional process of fabricating a light absorbing thin layer of CISG by forming and processing a metal precursor.
Fig. 3 illustrates a process of fabricating a light absorbing thin layer of CISG by forming and processing a metal precursor according to the present invention.
Fig. 4 illustrates a state of sputtered particles forming a metal precursor film by an opposite target type sputtering process according to the present invention.
Fig. 5 illustrates an example of heat-treatment of a metal precursor in a selenium atmosphere to form a thin layer of CIGS according to the present invention.
Fig. 6 is a schematic construction view of an exemplary industrial apparatus for fabricating light absorbing layers of solar cells by using the light absorbing layer forming process according to the present invention.

### PREFERRED EMBODIMENT OF THE INVENTION

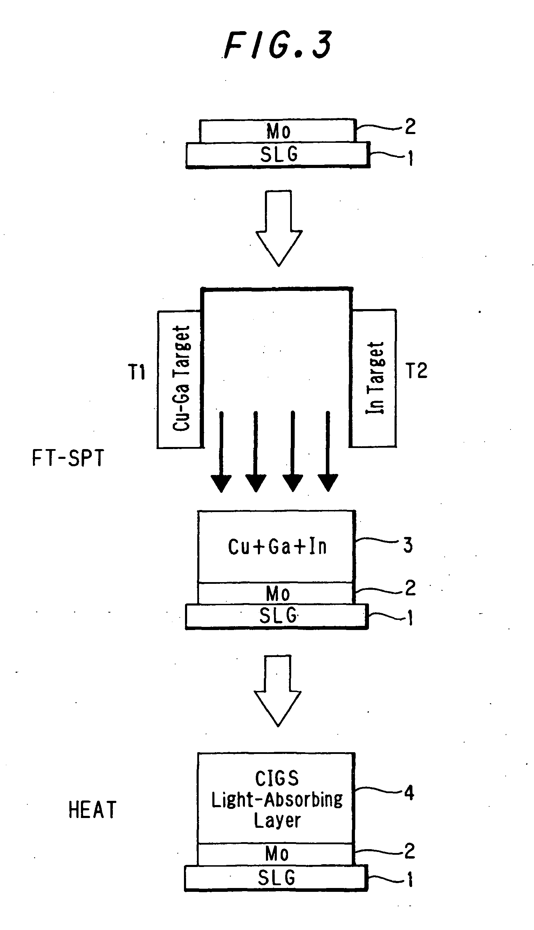

As shown in Fig. 3, a light absorbing thin layer fabricating method according to the present invention comprises a sputtering process FT-SPT for forming a metal precursor film 3 of Cu-Ga-In on a molybdenum (Mo) electrode layer 2 formed on a soda-lime glass (SLG) substrate 1 by depositing a mixture of particles sputtered at the same time from a pair of a copper-gallium (Cu-Ga) target T1 and an indium (In) target T2, disposed opposite to each other, and a heat treatment process HEAT for treating by heat the precursor film deposited on the Mo layer of the SLG substrate in a selenium atmosphere to complete the light absorbing layer 4 of CIGS.

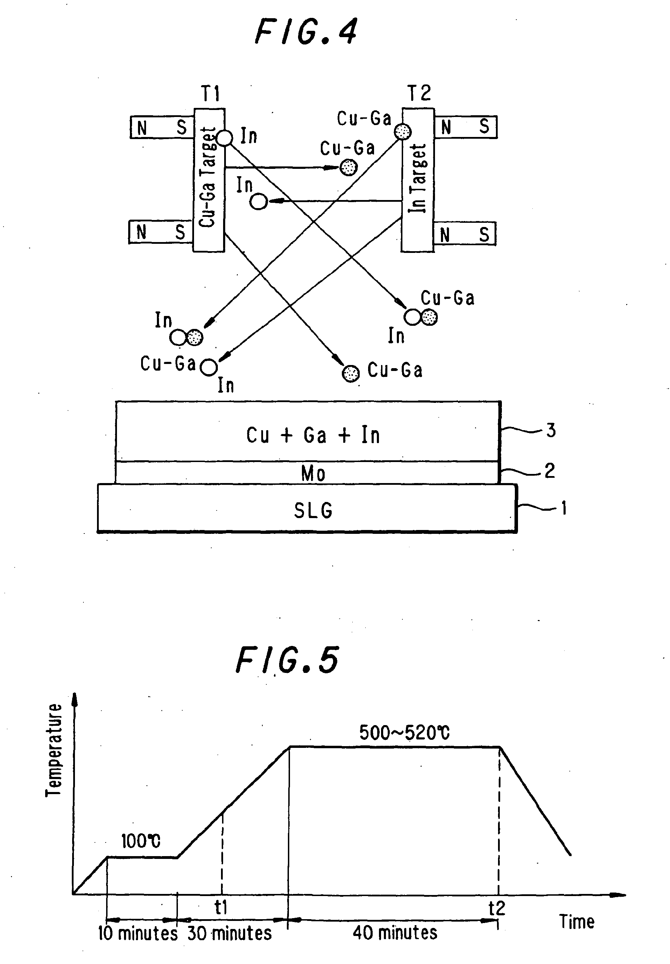

Fig. 4 illustrates the state of particles sputtered from the Cu-GA target T1 and the In target T2 when forming a single layer metal precursor 3 of mixed particles of Cu-GA-In.

When the Cu-Ga target T1 and the In target T2 were simultaneously excited, particles are sputtered from paired targets and reach the surfaces of the opposite targets. As a result, particles of three different metal elements Cu, Ga and In are mixed at the surface of each of the targets and then sputtered again therefrom and deposited onto the molybdenum electrode layer 2 of the substrate. An alloy precursor 3 of Cu, Ga and In is thus formed. In this instance, a part of particles sputtered from each of targets T1 (Cu-Ga) and T2 (In) may not be directed to the opposite target and is directly deposited on the electrode layer 4 but it is a very small amount because of the small probability of such sputtering angles. Most particles of three kinds of metal elements are deposited as well mixed state on the electrode layer formed on the substrate.

In the other words, the metal precursor 3 obtained by the method according to the present invention is composed of well mixed particles Cu-Ga-In deposited in a single layer whereas the metal cursor obtained by the conventional method are laminated of a thin layer of Cu-Ga and a thin layer of In.

As compared with the conventional laminated metal precursor, the metal precursor 3 of the present invention possesses the uniform distribution therein of metal elements Cu, Ga and In, which can prevent the progress of forming an alloy by diffusion of metal elements in solid layers. The precursor 3 thus obtained can be evenly selenized by the proceeding heat treatment process.

Consequently, the precursor thus formed and treated by heat to form the light absorbing layer can also prevent the occurrence of different crystal layer (different from the crystal structure to be expected) in the thin film compound semiconductor solar cell (a final product), which is a factor of deterioration of the solar cell. The precursor 3 has a pseudo amorphous structure which is effective to achieve a high quality of a thin CISG film of the light absorbing layer. The metal precursor 3 is an alloy composed of three metal elements, which can prevent the product solar cell from being short-circuited.

The above-described simultaneous sputtering of both targets T1 and T2 makes it possible to form the precursor 3 at a high speed. The precursor thus formed in a single thin layer composed of three metals (Cu, Ga, In) uniformly distributed therein is then treated by heat in an atmosphere of selenium (Se) to form a selenized thin-film of Cu (In+Ga) Se2, which is a light-absorbing layer (p-type semiconductor) possessing a high quality and high performance. The solar cell product having a light-absorbing layer 4 thus formed according to the present invention has been proved to show a power conversion efficiency exceeding 15%.

Fig. 5 shows an example of a heating temperature characteristic of a furnace wherein the precursor is treated by heat with H2Se gas (diluted with 5% argon gas) to form a CIGS thin film light-absorbing layer 4 by thermal chemical reaction with selenium (in gas phase). The furnace is first heated up to 100°C following by holding for 10 minutes for stabilizing the inside temperature of the furnace. The inside temperature is then increased gradually through a stable ramp-up period of about 30 minutes to 500~520°C at which the soda-lime glass (SLG) substrate with a precursor formed thereon may not be deformed and can be heat-treated to obtain the high quality crystal structure of the precursor. In the above heating process, selenium (Se) produced by thermal decomposition of H2Se gas is supplied from the time T1 when the inside temperature of the furnace reached to 230~250°C. In order to attain the high crystal structure of the CGIS thin film by high temperature treatment, the precursor of the substrate is treated for 40 minutes maintaining the furnace inside temperature of 500 to 520°C. The furnace is charged with H2Se gas from the time point T1 when the inside temperature reached 100°C. The precursor is treated by heat at a constant inside pressure of the furnace. When the heat treatment of the precursor was completed at the time point t2, the furnace gas is replaced by argon gas at a low pressure of about 100 Pa to prevent further unnecessary deposition of selenium.

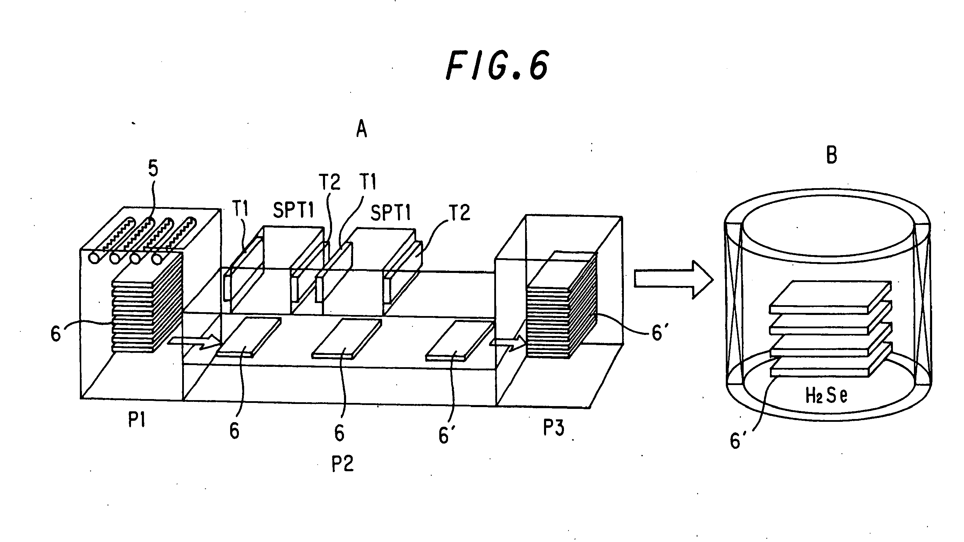

Fig. 6 illustrates an example of equipment for mass production of light-absorbing layers of solar cells by applying the light-absorbing layer forming method according to the present invention. The equipment comprises an inline thin-film forming apparatus A which includes a substrate feeding chamber P1 provided with a heater for storing a number of substrates 6 (SLG substrates each with a molybdenum electrode layer formed thereon) at a constant temperature and subsequently feeding the substrates 6, a precursor forming chamber P2 for forming a metal precursor layer on each of substrates 6 subsequently fed from the substrate feeding chamber P1 and placed by one at two sputtering portions SPT1 and SPT2 each provided with a pair of oppositely disposed targets T1 and T2 for simultaneously sputtering elements from the respective metal targets and a substrate cooling chamber P3 for receiving the substrates each with a precursor formed thereon from the precursor forming chamber P2 and temporarily storing and cooling the substrates; and an annealing apparatus B in which a number of the precursor-formed substrates 6' cooled and fed from the substrate cooling chamber P3 are treated by heat in a selenium (Se) atmosphere. Transport of the substrates 6 and 6' is conducted by a transporting mechanism operable under the control from a controller (not shown) in synchronism with the operation of the respective sputtering portions SPT1 and SPT2. In the inline film-forming apparatus A, it is possible to realize a gradient composition profile by using a plurality of Cu-Ga targets being different in content of Ga.

According to the present invention, when forming a metal precursor on a substrate by the opposite target type sputtering method, it is possible to use as paired opposite targets, not limited to a combination of Cu-Ga and In targets, other combinations of Cu-Ga and In targets, Cu and In or Al, and Cu and In-Cu. Basically, it is possible to apply a combination of twos of three metal groups Ib-IIIb (alloy metal), Ib (metal) and IIIb (metal).

### Industrial Applicability

As is apparent from the foregoing, the light-absorbing layer forming method according to the present invention can produce a thin-film CIGS light-absorbing layer by forming a thin-film precursor of Ib-IIIb group metals by sputtering and treating by heat the precursor in a selenium atmosphere, wherein particles are sputtered from a pair of oppositely disposed targets, one is a carrier of an alloy Ib group-IIIb group metals and the other is a carrier of single Ib group metal or IIIb group metal, and well mixed to form a thin-film single-layered precursor featured by even distribution therein metal elements sputtered from respective target materials, which precursor can also uniformly selenized by the following heat-treatment process. Thus, the application of the above-described method makes it possible to form a high quality light-absorbing layer at a high speed and can thereby contribute to improve the productivity of compound semiconductor solar cells.

According to the light-absorbing layer forming method of the present invention, a light-absorbing layer of a compound semiconductor solar cell can be produced by a process of forming a thin single layer of an alloy precursor by simultaneously sputtering Ib group metal element and IIIb group metal element and by a proceeding process of selenizing the formed precursor by exposing to selenium gas, wherein the thin-film precursor formed with well mixed Ib group and IIIb group metal elements and then uniformly selenized. Thus, the above method makes it possible to form a high-quality light-absorbing layer for a solar cell at a high speed and can thereby increase the productivity of compound semiconductor solar cells.

## Claims

1. A light absorbing layer forming method for manufacturing a CIGS thin-film solar cell comprising a first step of forming a thin-film precursor of Ib-IIIb group metal by a sputtering technique followed by a second step of treating the formed precursor by heat in a selenium atmosphere to form a thin-film light-absorbing layer of CIGS, **characterized in that** in said first step two different metal targets disposed parallel and opposite to each other are simultaneously excited to sputter particles which reach the surfaces of the opposite targets whereat the particles are mixed with different metal elements of each of the opposite targets and wherefrom the mixed particles of different elements are further sputtered to deposit in a single layer on a substrate for forming thereon a thin-film single-layered precursor.

2. A light-absorbing layer forming method as defined in claim 1, wherein the paired targets are of a combination of two of three different kinds of metals:
an alloy of a Ib group metal and a IIIb group metal; a Ib group metal; and IIIb group metal.

3. A light absorbing layer forming method as defined in claim 2, wherein the alloy of the Ib group metal and the IIIb group metal is of Cu-Ga or Cu Al or IN-Cu, the Ib group metal is Cu, and the IIIb group metal is In or Al.

## Patentansprüche

1. Verfahren zur Bildung einer Licht absorbierenden Schicht zur Herstellung einer CIGS-Dünnfilmsolarzelle, umfassend einen ersten Schritt der Bildung eines Dünnfilm-Vorläufers von Gruppe lb-Illb-Metallen durch Sputtern, gefolgt von einem zweiten Schritt der Behandlung des gebildeten Vorläufers durch Hitze in einer Selen-Atmosphäre, um eine Licht absorbierende Dünnfilmschicht aus CIGS zu bilden, **dadurch gekennzeichnet, dass** in dem ersten Schritt zwei unterschiedliche Metall-Targets, die parallel zueinander und gegenüberliegend voneinander angeordnet sind, gleichzeitig angeregt werden, um Partikel zu sputtern, die die Oberflächen der gegenüberliegenden Targets erreichen, wobei die Partikel mit unterschiedlichen Metallelementen von jedem der gegenüberliegenden Targets gemischt werden und wobei die gemischten Partikel der unterschiedlichen Elemente weiter gesputtert werden, um sich in einer Einschicht auf einem Substrat abzusetzen, um darauf einen Dünnfilm-Einschicht-Vorläufer zu bilden.

2. Verfahren zur Bildung einer Licht absorbierenden Schicht nach Anspruch 1, wobei die gepaarten Targets aus einer Kombination von zwei oder drei unterschiedlichen Arten von Metallen sind:
eine Legierung eines Gruppe Ib-Metalls und eines Gruppe Illb-Metalls-, eines Gruppe Ib-Metalls; und Gruppe IIIb-Metalls.

3. Verfahren zur Bildung einer Licht absorbierenden Schicht nach Anspruch 2, wobei die Legierung des Gruppe Ib-Metalls und des Gruppe IIIb-Metalls aus Cu-Ga oder Cu Al oder IN-Cu besteht, das Gruppe Ib-Metall Cu ist und das Gruppe IIIb-Metall In oder Al ist.

## Revendications

1. Procédé de formation d'une couche absorbant la lumière pour fabriquer une pile solaire à film mince CIGS comprenant une première étape de formation d'un film mince de précurseur en un métal du groupe Ib-IIIb par une technique de pulvérisation cathodique suivie par une seconde étape de traitement du précurseur formé par de la chaleur dans une atmosphère de sélénium pour former un film mince de CIGS absorbant la lumière, **caractérisé en ce que** dans ladite première étape, deux cibles en métal différentes disposées parallèlement et opposées l'une à l'autre sont simultanément excitées pour pulvériser cathodiquement des particules qui atteignent les surfaces des cibles opposées où les particules sont mélangées avec différents éléments de métal de chacune des cibles opposées et à partir desquelles les particules mélangées de différents éléments sont encore pulvérisées cathodiquement pour se déposer en une seule couche sur un substrat pour y former un film mince de précurseur à une seule couche.

2. Procédé de formation d'une couche absorbant la lumière selon la revendication 1, dans lequel les cibles appariées sont une combinaison de deux parmi trois types différents de métaux :
un alliage d'un métal du groupe Ib et d'un métal du groupe IIIb ; un métal du groupe Ib ; et un métal du groupe IIIb.

3. Procédé de formation d'une couche absorbant la lumière selon la revendication 2, dans lequel l'alliage du métal du groupe Ib et du métal du groupe IIIb est en Cu-Ga ou Cu-Al ou In-Cu, le métal du groupe Ib est Cu, et le métal du groupe IIIb est In ou Al.
